# EUROPEAN PATENT APPLICATION

(11) **EP 2 871 587 A1**
(43) Date of publication of application: **13.05.2015**
(21) Application number: 13192010.0
(22) Date of filing: 07.11.2013
(51) Int. Cl.: G06F 17/50

(54) **A method and tool for designing an electrical panel/cabinet**

(71) Applicant: Easy Panel N.V., 3550 Heusden-Zolder (BE)
(72) Inventor: Mouchaers, Bernd, 3730 Hoeselt (BE)
(74) Representative: Plas, Axel Ivo Michel

(57) **Abstract**

A computer-implemented method for designing an electrical panel/cabinet comprises the steps of:
A. requiring a user to specify at least one applicable norm for the electrical panel/cabinet, either directly or indirectly;
and iteratively:
B1. enabling the user to virtually add an additional component to the electrical panel/cabinet by placing in a graphical user interface (400) the additional component on a wiring diagram (402) of the electrical panel/cabinet; and
B2. verifying and requiring compliancy with the at least one applicable norm before enabling the user to move to a following step wherein mechanical parameters for the electrical panel/cabinet are specified.

## Description

### Field of the Invention

The present invention generally relates to a computer-implemented method and tool for designing an electrical panel/cabinet, typically a custom-made electrical panel/cabinet for use in a residential or industrial environment. Designing an electrical panel/cabinet in the context of the present invention means selecting an electrical cabinet and panel, and configuring the selected electrical panel with components. The present invention in particular describes a component manufacturer independent computer-implemented method and tool for designing an electrical panel/cabinet that guarantees norm compliant and best practice compliant configuration.

### Background of the Invention

Electrical component manufacturers typically have their proprietary tool for configuring an electrical panel/cabinet. These existing tools enable to configure an electrical panel/cabinet with components of a single manufacturer. Apart from the fact these tools do not guarantee norm-compliant configuration and/or configuration in accordance with technicians best practices, these tools do not configure an electrical panel/cabinet with optimal components at a best price. In other words, there is a need for component manufacturer independent tools that configure electrical panels/cabinets.

United States Patent Application US 2011/0093356 entitled "Cost Estimation Systems, Methods, and User Interfaces for Configurable Electrical Panels" describes a computer-implemented method and system for configuring an electrical panel according to custom specifications. The system known from US 2011/0093356 is advantageous in its flexibility for selecting components from multiple component manufacturers and enables to generate a price quote for a customized electrical panel/cabinet. US 2011/0093356 mainly describes a quote generator for an electrical panel that is configured with components from different manufacturers, but fails to deliver a complete technical specification.

Although US 2011/0093356 mentions in paragraph [0064] that engineering logic rules may be applied by the system to prevent a user from selecting problematic combinations of components, it is not clear what such engineering logic rules entail, and it is definitely not guaranteed that the electrical panel configured with the system of US 2011/0093356 is norm compliant, i.e. compliant with the standards applicable to the environment or application wherein the electrical panel/cabinet will be used.

It is an objective of the present invention to resolve the above-mentioned shortcomings of prior art tools for configuration of electrical panels/cabinets. More particularly, it is an objective to disclose a computer-implemented method and system for designing an electrical panel/cabinet that is component manufacturer independent, and that guarantees norm compliant and best practice compliant configuration of customized electrical panels/cabinets. Embodiments of the computer-implemented method and system according to the present invention are further advantageous in many aspects, as will be explained in the paragraphs below.

### Summary of the Invention

In accordance with the present invention, the above defined objectives are realized by the computer-implemented method for designing an electrical panel/cabinet of claim 1, comprising the steps of:
A. requiring a user to specify at least one applicable norm for the electrical panel/cabinet, either directly or indirectly;
   and iteratively:
   B1. enabling the user to virtually add an additional component to the electrical panel/cabinet by placing in a graphical user interface the additional component on a wiring diagram of the electrical panel/cabinet; and
   B2. verifying and requiring compliancy with the at least one applicable norm before enabling the user to move to a following step wherein mechanical parameters for the electrical panel/cabinet are specified.

Thus, in accordance with the present invention, the user shall virtually place components on a wiring diagram, e.g. via a drag and drop graphical user interface that makes use of peripherals like a computer mouse, keyboard, joystick, etc. or through touch and slide in case the graphical user interface is run on a device with touchscreen. Each time a component is placed on the wiring diagram, compliancy of all components already placed on the wiring diagram is verified, and the user is not allowed to move to a following step wherein mechanical parameters for the electrical panel/cabinet are specified until non-compliancy issues have been resolved. Compliancy is verified with a norm or standard that is identified by the user as applicable to the electrical panel/cabinet. The user may enter or select this norm directly, e.g. the IEC 60898 or IEC 60947 norm, or may indicate which norm is applicable indirectly, e.g. by indicating that the electrical panel/cabinet will be used in a residential or industrial installation, by entering or selecting the operating voltage, the nominal current and/or the short circuit current, by selecting the net system, etc.

In a preferred embodiment of the computer-implemented method according to the present invention, defined by claim 2, verifying compliancy with the at least one applicable norm comprises:
for each component already virtually placed on the electricity panel, including the additional component:
   - determining the type of component in a component database;
   - determining the rules applicable to the type of component in a rule database comprising norm related rules and best practice rules;
   - verifying if the rules applicable to the type of component are respected by the component; and
   - reporting which rules are not respected and requesting the user to resolve rules that are not respected.

Thus, in a preferred embodiment of the invention, components of multiple manufacturers are classified per type in a component database. Further, a rule database is maintained wherein for each type of component, the applicable rules are specified. The rules preferably comprise rules mandatory for compliancy with certain norms or standards but also rules of good workmanship, i.e. best practice rules applied by technicians. For all components already virtually placed on the electricity panel, e.g. through drag and drop on the wiring diagram in the graphical user interface, compliancy with all rules that are applicable to that type of component is verified. Rules not complied with are reported to the user, e.g. though a pop-up screen with message specifying the non-satisfied rule, and the user is not allowed to move to a following step wherein mechanical parameters for the electrical panel/cabinet are specified until the non-satisfied rule is resolved.

Optionally, as defined by claim 3, the computer-implemented method according to the present invention further comprises:
C1. requiring the user to specify panel and cabinet parameters;
C2. automatically selecting a panel/cabinet matching the parameters; and
C3. notifying to the user attention points related to the panel/cabinet selected.

Hence, the user may specify the preferred parameters for the electrical panel/cabinet in an advantageous embodiment of the present invention. These parameters may include for instance the choice of material of the panel/cabinet, e.g. metal or plastic, the mounting structure, the presence or absence of a cable conduit, the type of lock, ... It is noticed however that certain parameters of the electrical panel/cabinet may have been determined already as a result of norm selection by the user either directly or indirectly in step A, or as a result of the automated rule verification and required norm compliancy in steps B1 and B2. According to an advantageous aspect of the method according to the invention, the user is then automatically notified of certain attention points related to the panel/cabinet selection. The user may for instance be notified that a residential TT compliant installation requires a plastic panel. In another example, the user may be notified that a first panel in an installation with multiple panels, e.g. in a multi-floor or apartment building, needs to have a differential switch, etc. Non-compulsory rules of the applicable norm(s) may further also be integrated in this help function.

As specified by claim 4 and already mentioned here above, the panel and cabinet parameters that can be specified by the user in embodiments of the present invention comprise at least one of:
- a material;
- a mounting structure;
- a lock type; and
- presence or absence of a cable conduit.

According to a further optional aspect defined by claim 5, the computer-implemented method according to the current invention further comprises:
D. enabling the user to select measuring components and/or to select power supply components for control components already virtually added to the electrical panel/cabinet.

Indeed, in an advantageous embodiment of the present invention, the user is prompted to add power supply components such that the panel can be wired correctly. In case the user does not add power supply components, e.g. because the power is supplied from a different panel, the computer-implemented method according to the present invention preferably automatically foresees terminals enabling the installer to connect the power supply later.

According to yet another advantageous aspect defined by claim 6, the computer-implemented method according to the invention further comprises:
E1. automatically determining mechanical elements that are needed to configure the electrical panel with all components virtually added thereto.

As is further specified by claim 7, these mechanical elements may comprise at least one of:
- a terminal;
- a bus bar;
- a duct; and
- a bridging element or connection rail.

The software-implemented method according to the present invention hence automatically determines these additional mechanical elements, required to properly configure the panel.

Further optionally, as specified by claim 8, the computer-implemented method according to the present invention may coprise:
E2. generating a panel layout for the electrical panel.

Indeed, the method preferably produces a panel layout from the wiring diagram, that can be of assistance to the installer.

According to yet another optional aspect, defined by claim 9, the computer-implemented method according to the invention further comprises:
E3. generating production data for the electrical panel.

As is specified by claim 10, these production data may comprise at least one of:
- a list of materials;
- a sticker;
- a label; and
- engraving instructions.

An advantage thereof is that the installer need not separately or manually generate the stickers or labels for labelling the electrical panel/cabinet. Such separate or manual production of stickers and labels is more error-prone and cumbersome to the installer. As an alternative to stickers or labels, or in addition thereto, the panel/cabinet or components used therein may be engraved. Automatic production of the engraving instructions again is less error-prone than separate or manual production of such instructions.

In addition to a computer-implemented method for designing an electrical panel/cabinet as specified by claim 1, the present invention relates to a corresponding data processing system as defined by claim 11, comprising means for carrying out such method.

Further, the present invention relates to a computer program as defined by claim 12, comprising software code adapted to perform the method according to the present invention, and to a computer readable storage medium as defined by claim 13, comprising the computer program.

### Brief Description of the Drawings

Fig. 1 shows an embodiment of the data processing system 100 according to the present invention carrying out an embodiment of the method according to the present invention;
Fig. 2 illustrates the data structure used in rules database 104 in the embodiment of the invention illustrated by Fig. 1;
Fig. 3 is a first graphical user interface screenshot illustrating a first step in an embodiment of the method according to the present invention wherein the user specifies an applicable norm and the general parameters for an electrical panel/cabinet under configuration;
Fig. 4 is a second graphical user interface screenshot illustrating a second step in an embodiment of the method according to the present invention wherein the user adds a component to a wiring diagram of the panel/cabinet under configuration as a result of which norm compliancy is verified;
Fig. 5 is a third graphical user interface screenshot illustrating a third step in an embodiment of the method according to the present invention wherein the user specifies mechanical parameters for the panel/cabinet under configuration;
Fig. 6 is a fourth graphical user interface screenshot illustrating a fourth step in an embodiment of the method according to the present invention wherein the user selects optional electrical components for the panel/cabinet under configuration; and
Fig. 7 is a fifth graphical user interface screenshot illustrating a fifth step in an embodiment of method according to the present invention wherein the user specifies final parameters for the panel/cabinet under configuration.

### Detailed Description of Embodiment(s)

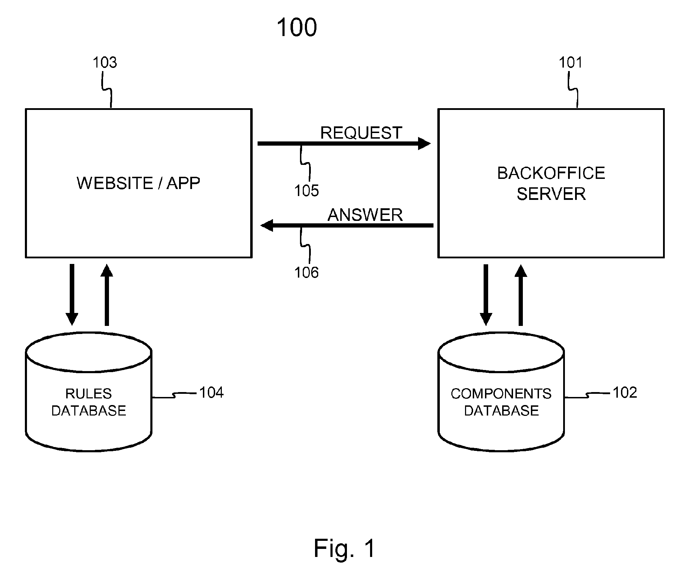

The system drawn in Fig. 1 consists of a back-office server 101, a components database 102, a website or application server 103 accessible from client devices, and a rules database 104. The back-office server 101 makes all calculations to configure the electrical panel/cabinet. It calculates the positions and dimensions of all components, links all mechanical components and produces detailed CAD data for the electrical and mechanical configuration of the panel/cabinet. The back-office server 101 thereto interacts with the components database 102 that stores all data related to electrical and mechanical components of diverse component manufacturers that could be used in configuring electrical panels/cabinets. The system 100 further has a website server or application server 103 that runs a graphical user interface enabling the user to select options and components for an electrical panel/cabinet under configuration. The website/application server 103 interacts with a rules database 104 that lies at the basis of the present invention. The website/application server 103 checks electrical errors, i.e. non-compliancy with an applicable norm or best practice rules, and warns the user of such errors. The website/application server 103 thereto relies on rules that are stored for different types of components in the rules database 104.

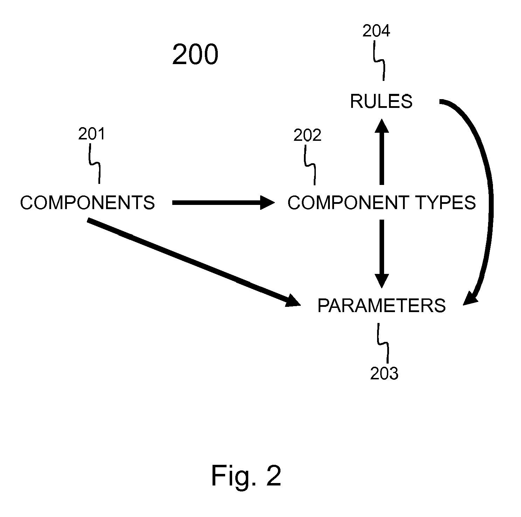

Fig. 2 shows the data structure, i.e. the different data tables and their links, in the rules database 104 of Fig. 1. The components table 201 contains all the physical components or parts from different manufacturers supplying electrical or mechanical components for configuring electrical panels/cabinets. The component type table 202 contains all types or categories of components that can be used to configure electrical panels/cabinets. Types of components are for instance circuit breakers, fuses, contactors, power supplies, ... Each component listed in the components table 201 is of a specific component type and consequently linked to the component type table 202. Each component type further has a limited set of parameters where it is linked to in the parameters table 203, and a limited set of rules where it is linked to in the rules table 204. The parameters table 203 contains all parameters or attributes that are used by components, like for instance the current, the voltage, the amount of poles, etc. The rules table 204 on the other hand contains all rules that result from applicable norms or standards or that result from best practices. Each rule is linked to a parameter in the parameter table 203 and defines conditions to be satisfied by that parameter. An example rule may for instance specify that the current has to be greater than the current of its parent component. It is further noticed that each component in the components table 201 has specific values for the parameters that are linked to its component type. Further, it is noticed that for each component in the components table 201 the rules that are linked to its component type are applicable.

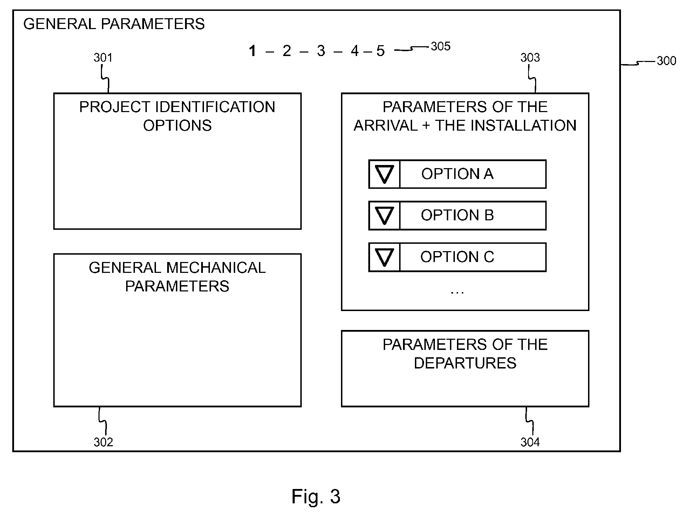

The graphical user interface screenshot 300 depicted in Fig. 3 illustrates step 1 out of the 5 steps 305 the user has to go through to configure an electrical panel/cabinet. The screenshot 300 contains a first section 301 where the user specifies project identification options such as the project name, the name of he panel/cabinet, and an eventual description of the panel/cabinet. In a second section 302, the user is enabled to specify general mechanical parameters of the panel/cabinet such as the percentage of spare space that is desired, the type of lock and whether or not wire numbering is desired. Essential to the present invention is the third section 303 that enables the user to directly or indirectly select an applicable norm, e.g. by specifying the parameters of arrival and installation. These parameters may for instance entail the type of installation, i.e. residential or industrial, the nominal current, the operational voltage, the type of grounding, i.e. either TT or TNS, the short circuit current, and the type of arrival. These parameters may be entered by typing their respective values or they may be selected from a drop down lists in case the possible values are limited. The section 303 may also contain fields that allow the user to directly enter or select an applicable norm, e.g. IEC 60898 or IEC 60947. This may for instance be implemented through radio buttons in screenshot 303. At last screenshot 300 has a fourth section 304 wherein the user is enabled to specify parameters of departure, such as the presence/absence of push-in terminals.

In summary, in the first step, the user selects either directly or indirectly, e.g. by indicating that the panel/cabinet shall be used in residential or industrial environment, which norm(s) are applicable. Also other general parameters like the nominal current and operational voltage are selected. These general parameters serve as basic values for the automated norm verification in step 2.

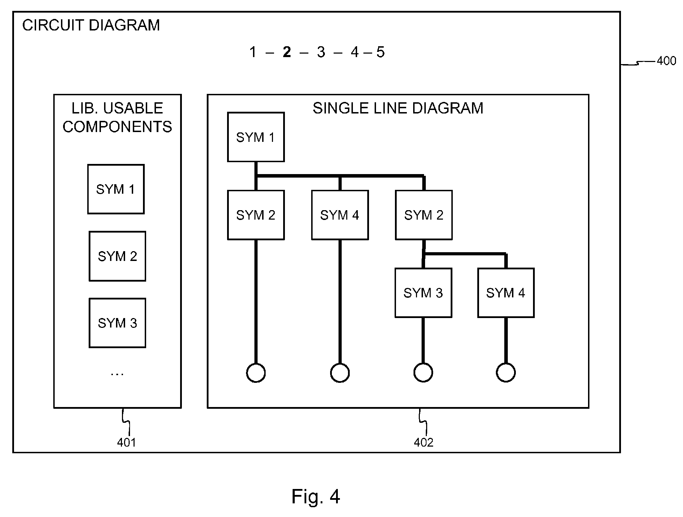

The graphical user interface screenshot 400 depicted in Fig. 4 illustrates the second step where the user has to go through in order to configure his electrical panel/cabinet. The screenshot 400 contains a first section 401 listing a library of usable components available for the user in panel/cabinet configuration. The library is organized per type of component, e.g. circuit breakers, fuses, power switches, earth leakage circuit breakers, contactors, ..., and each type of component is represented by a different symbol SYM 1, SYM 2, SYM 3, ... in section 401. The screenshot 400 further contains a second section 402 showing the wiring diagram of the electrical panel/cabinet under configuration. Through drag and drop actions, the user can add components from the library in 401 to the wiring diagram in 402. Each time a component is added to the wiring diagram 402, automated norm verification will take place. Thereto, it is verified to which component type the component belongs. Further, rules database 104 is consulted to select the applicable rules for that component type. For instance, a rule may specify the lower bound for the nominal current of a component. These rules guarantee norm compliancy and best practice configuration. When one of the rules applicable for one of the components on the wiring diagram is no longer satisfied as a result of the addition or the change of a component, the user is informed and he is not allowed to continue with the next step of the configuration of the electrical panel/cabinet until compliancy with all rules applicable to all components placed on the wiring diagram is achieved. Components that are invalid, i.e. whose rules are not all satisfied, may for instance be shown in a different color on the wiring diagram. These components must be removed or replaced before the user can proceed to the next step wherein mechanical parameters for the electrical panel/cabinet are specified.

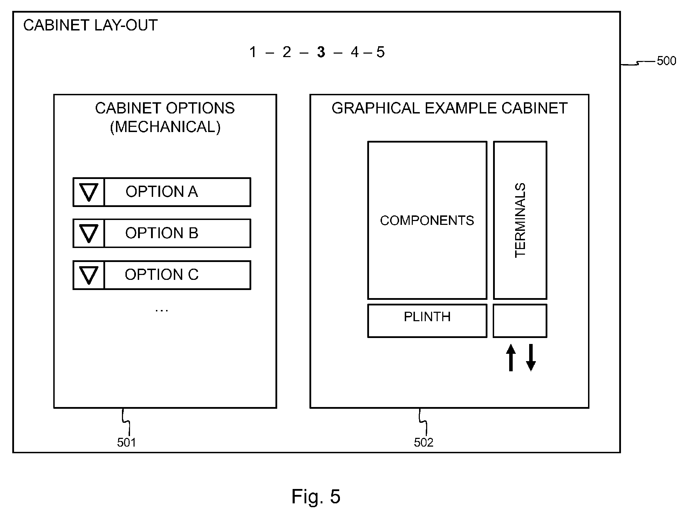

The graphical user interface screenshot 500 depicted in Fig. 5 illustrates the third step taken by the user when configuring his electrical panel/cabinet. In this third step, the user determines mechanical parameters of the panel/cabinet that were not yet specified in the first step. The different mechanical options, e.g. OPTION A, OPTION B, OPTION C, ... are listed in a first section 501 of screenshot 500. The mechanical parameters of the panel/cabinet that may be specified here for instance include the choice of the material, e.g. metal or plastic, the mounting structure, the presence/absence of a cable conduit, etc. While selecting the mechanical options in section 501, the layout of the panel/cabinet is graphically displayed in section 502. The software application according to the invention matches the mechanical parameters selected by the user with a panel/cabinet database and selects the panel/cabinet. Further, the user is automatically notified on certain attention points. For instance, the fact that a residential TT compliant installation requires a plastic panel, a first panel needs to have a differential switch, the incoming cable needs to be double-isolated in case the first cabinet in a TT compliant installation is not plastic, etc., is notified to the user through pop-up messages. Additional, non-compulsory rules of the norm are integrated in the help function.

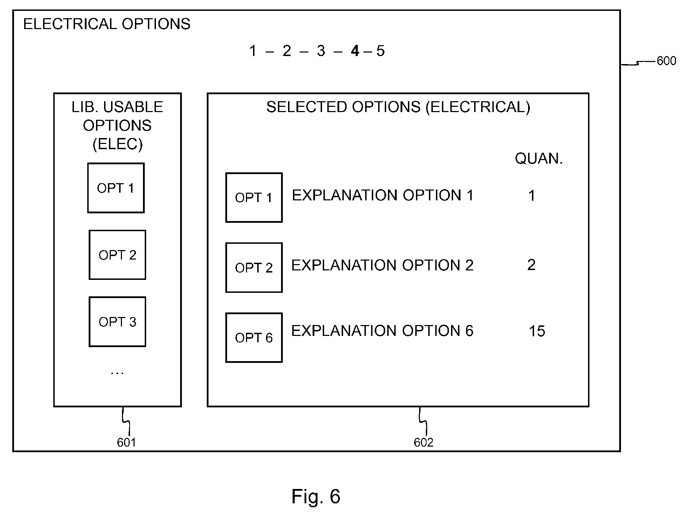

The graphical user interface screenshot 600 depicted in Fig. 6 illustrates the fourth step the user takes in configuring his electrical panel/cabinet. In this fourth step, the user can select additional electrical components for the panel/cabinet, like for instance measuring components or power supplies. The library of additional electrical components usable is listed in section 601 of screenshot 600. The selected additional electrical components, their quantities and an explanation is displayed in section 602 of screenshot 600. The user is guided by the software in the selection of additional electrical components through pop-up messages and warnings. For all control elements placed on the wiring diagram for instance, the user shall be prompted to add power supply components so the panel can be wired correctly. In case no power supply components are foreseen for a control element, e.g. because powering comes from another panel, the software will automatically foresee terminals.

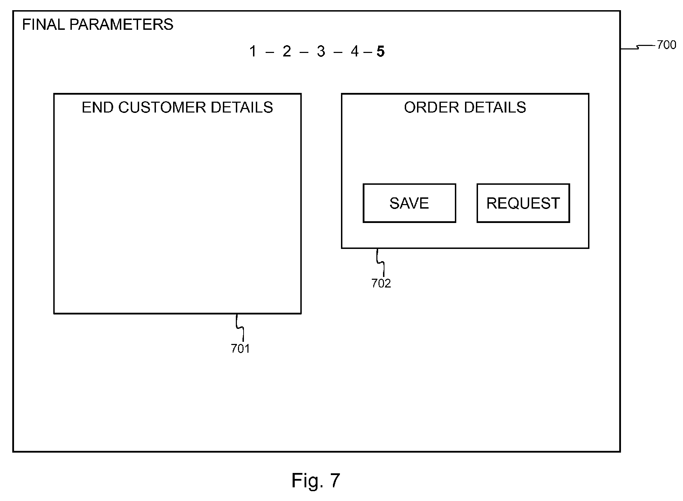

The graphical user interface screenshot 700 depicted in Fig. 7 illustrates a fifth step the user takes when configuring his electrical panel/cabinet. The user specifies the end customer details in section 701. The order details are then summarized in section 702 and the user can save the configuration or request an offer for the panel/cabinet. After the offer is approved by the user, the software program automatically generates the CAD drawings. In addition, the software automatically determines additional mechanical elements that are required to configure the panel. Examples of such additional mechanical elements are terminals, bridging elements, bus bars, ducts, the type of door, etc. A panel/cabinet layout is generated automatically.

The method according to the invention shall typically be computer-implemented to run on a data processing system or computing device. A data processing system or computing device that is operated according to the present invention can include a workstation, a server, a laptop, a desktop, a hand-held device, a mobile device, a tablet computer, or other computing device, as would be understood by those of skill in the art.

The data processing system or computing device can include a bus or network for connectivity between several components, directly or indirectly, a memory or database, one or more processors, input/output ports, a power supply, etc. One of skill in the art will appreciate that the bus or network can include one or more busses, such as an address bus, a data bus, or any combination thereof, or can include one or more network links. One of skill in the art additionally will appreciate that, depending on the intended applications and uses of a particular embodiment, multiple of these components can be implemented by a single device. Similarly, in some instances, a single component can be implemented by multiple devices.

The data processing system or computing device can include or interact with a variety of computer-readable media. For example, computer-readable media can include Random Access Memory (RAM), Read Only Memory (ROM), Electronically Erasable Programmable Read Only Memory (EEPROM), flash memory or other memory technologies, CDROM, digital versatile disks (DVD) or other optical or holographic media, magnetic cassettes, magnetic tape, magnetic disk storage or other magnetic storage devices that can be used to encode information and can be accessed by the data processing system or computing device.

The memory can include computer-storage media in the form of volatile and/or nonvolatile memory. The memory may be removable, non-removable, or any combination thereof. Exemplary hardware devices are devices such as hard drives, solid-state memory, optical-disc drives, or the like. The data processing system or computing device can include one or more processors that read data from components such as the memory, the various I/O components, etc.

The I/O ports can allow the data processing system or computing device to be logically coupled to other devices, such as I/O components. Some of the I/O components can be built into the computing device. Examples of such I/O components include a microphone, joystick, recording device, game pad, satellite dish, scanner, printer, wireless device, networking device, or the like.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A computer-implemented method for designing an electrical panel/cabinet, comprising the steps of:
A. requiring a user to specify at least one applicable norm for said electrical panel/cabinet, either directly or indirectly;
and iteratively:
B1. enabling said user to virtually add an additional component to said electrical panel/cabinet by placing in a graphical user interface (400) said additional component on a wiring diagram (402) of said electrical panel/cabinet; and
B2. verifying and requiring compliancy with said at least one applicable norm before enabling said user to move to a following step wherein mechanical parameters for said electrical panel/cabinet are specified.

2. The computer-implemented method according to claim 1, wherein verifying compliancy with said at least one applicable norm comprises:
for each component already virtually placed on said electricity panel, including said additional component:
- determining the type of component in a component database (102);
- determining the rules applicable to said type of component in a rule database (104) comprising norm related rules and best practice rules;
- verifying if said rules applicable to said type of component are respected by said component; and
- reporting which rules are not respected and requesting said user to resolve rules that are not respected.

3. The computer-implemented method according to claim 1 or claim 2, further comprising:
C1. requiring said user to specify panel and cabinet parameters (501);
C2. automatically selecting a panel/cabinet matching said parameters; and
C3. notifying to said user attention points related to said panel/cabinet selected.

4. A computer-implemented method according to claim 3, wherein said panel and cabinet parameters comprise at least one of:
- a material;
- a mounting structure;
- a lock type; and
- presence or absence of a cable conduit.

5. A computer-implemented method according to any one of the preceding claims, further comprising:
D. enabling said user to select measuring components and/or to select power supply components (601) for control components already virtually added to said electrical panel/cabinet.

6. A computer-implemented method according to any one of the preceding claims, further comprising:
E1. automatically determining mechanical elements that are needed to configure said electrical panel with all components virtually added thereto.

7. A computer-implemented method according to claim 5, wherein said mechanical elements comprise at least one of:
- a terminal;
- a bus bar;
- a duct; and
- a bridging element or connection rail.

8. A computer-implemented method according to any one of the preceding claims, further comprising:
E2. generating a panel layout for said electrical panel.

9. A computer-implemented method according to any one of the preceding claims, further comprising:
E3. generating production data for said electrical panel.

10. A computer-implemented method according to claim 9, wherein said production data comprise at least one of:
- a list of materials;
- a sticker;
- a label; and
- engraving instructions.

11. A data processing system (100) comprising means for carrying out the method of any of claims 1 to 10.

12. A computer program comprising software code adapted to perform the method of any of claims 1 to 10.

13. A computer readable storage medium comprising the computer program of claim 12.
